# EUROPEAN PATENT APPLICATION

(11) **EP 0 738 893 A2**
(43) Date of publication of application: **23.10.1996**
(21) Application number: 96302646.3
(22) Date of filing: 16.04.1996
(51) Int. Cl.: G01R 11/02, G01R 21/133, G01R 19/00

(54) **Synchronous detector circuit arrangement**

(30) Priority: 19.04.1995 GB 9507977
(71) Applicant: THE GENERAL ELECTRIC COMPANY, p.l.c., London W1A 1EH (GB)
(72) Inventor: Jones, Alan John, Clayton, Newcastle, ST5 3BA (GB); Benson, Robert Trevor, Willington, Tarporley, Cheshire, CW6 0NF (GB); Mills, Jonathan David, Stone, Staffordshire, ST15 8BT (GB)
(74) Representative: Cockayne, Gillian

(57) **Abstract**

A synchronous detector circuit arrangement (30) is provided for detecting a signal of interest in an input signal, in which the input signal comprises a signal at a selected frequency which is modulated by the signal of interest and by an unwanted signal. The circuit arrangement comprises signal combining means (33) for combining the input signal with a correction signal (34); a synchronous detector (14) connected to the output of the signal combining means and operated at the selected frequency for detecting the signal of interest; and means (40, 43, 44) for generating the correction signal such that in operation the correction signal is a signal at the selected frequency, is in antiphase with the input signal and has an amplitude which is selected such as to at least partially cancel the unwanted signal.

## Description

This invention relates to a synchronous detector circuit arrangement and is more particularly, though not exclusively, concerned with an optical pick-up including such a circuit arrangement for use with a commodity consumption meter.

With the privatisation of many of the utility companies providing metered commodities such as electricity, water or gas, and the resultant need to improve efficiency, current trends are towards developing remote reading systems which enable a consumer's commodity consumption meter to be read remotely without the need to gain access to the consumer's premises. Remote reading systems require an electronic signal which is related to the rate of consumption, or number of units of the commodity consumed.

Although electronic electricity consumption meters are available with electronic outputs, there are estimated to be in excess of twenty million Ferraris-type mechanical electricity consumption meters currently in operation within the UK which have an operating life expectancy of up to twenty-five years. As regards water and gas consumption meters, the majority of these are mechanical. To replace all of these consumption meters with electronic consumption meters would not be cost effective and alternative ways of utilising these existing consumption meters are preferred.

A feature that is generally common to mechanical commodity consumption meters is some form of rotating component such as a rotating disc, drum or pointer whose rate of rotation is related to the rate of consumption of the commodity. It is known to have an optical pick-up which detects rotation of such a component and produces an electrical pulse for each rotation of the component.

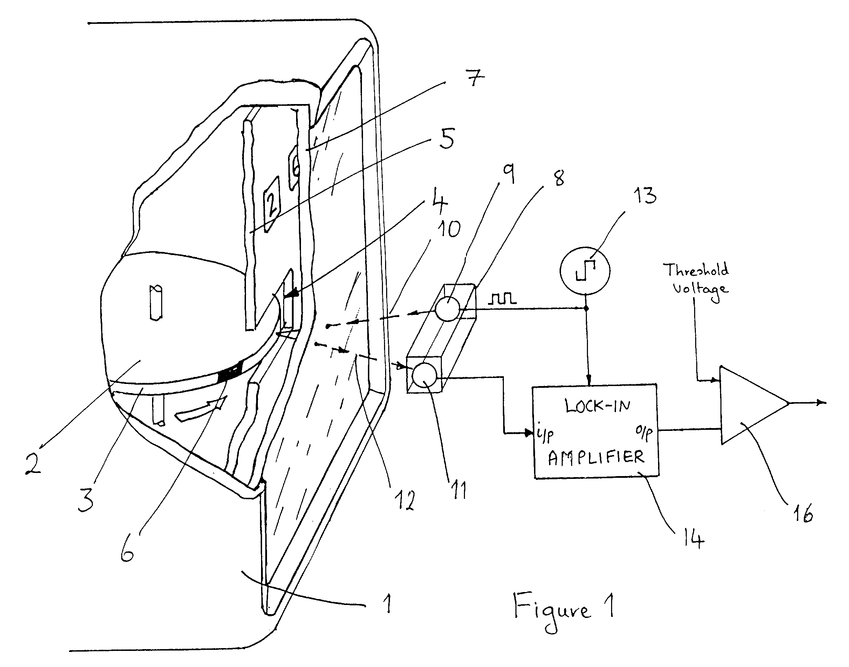

An example of a known optical pick-up is shown in Figure 1. The Figure shows a cutaway perspective view of a Ferraris-type electricity consumption meter 1 of a known type which includes a disc 2 whose rate of rotation depends upon the rate of consumption of electricity and an edge 3 of which is visible through an aperture 4 in an internal front panel 5. A mark 6 on the edge 3 allows rotation of the disc 2 to be observed through a window 7 in a front face of the meter 1. An optical sensor assembly 8 is affixed to the window 7. For the purposes of the description the optical sensor assembly 8 is shown away from the window 7 for clarity.

The optical sensor assembly 8 comprises a light emitting diode (LED) 9 which is arranged to direct light 10 through the window 7 onto the edge 3 and a photodetector 11 for detecting reflected light 12.

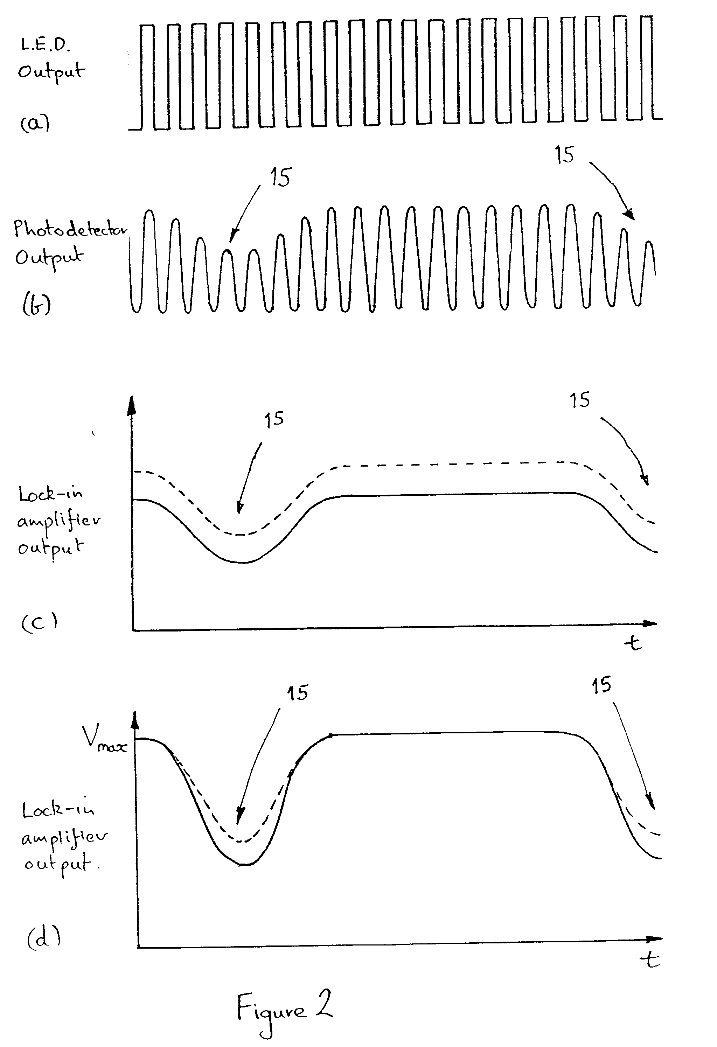

To reduce the effects of stray light such as sunlight, incandescent or fluorescent light the optical pick-up includes a synchronous detector circuit arrangement. Light 10 from the LED 9 is modulated at a selected frequency by driving the LED 9 from an oscillator 13 to produce short duration pulses of light (Figure 2(a)). The output from the photodetector 11 (Figure 2(b)), which comprises a signal at the selected frequency whose amplitude depends upon the intensity of the reflected light 12, is synchronously demodulated using a lock-in amplifier 14 to produce the output signal of Figure 2(c). From Figure 2(c) it can be seen that for each revolution of the disc 2 a drop in output 15 occurs when the mark 6 passes the optical sensor assembly 8. A voltage comparator 16 connected to the ouput of the lock-in amplifier 14 is used to compare the ouput signal with an appropriate threshold voltage to produce an electrical pulse for each rotation of the disc 2.

Whilst the lock-in amplifier circuit 14 increases the optical pick-up's ability to detect rotation of the disc 2 by discriminating against ambient light or other modulated signals which are not at the selected frequency, the inventors have realised that such an arrangement has disadvantages.

Firstly, the modulation of amplitude of the reflected light 12 due to the mark 6 is slight, especially when the edge 3 of the disc 2 is corroded or when the mark 6 is worn. Accordingly the drop 15 in output is small, making reliable detection of the mark 6 difficult. Although increasing the contrast between the mark 6 and the remainder of the edge 3 of the disc, by for example polishing the edge of the disc or repainting the mark, would increase the size of the drop 15 this would not be desirable. This is because electricity consumption meters have a casing which is sealed by an appropriate authority, often the meter manufacturer, to certify the accuracy of the meter whilst the seal remains unbroken. To gain access to the edge 3 of the disc 2 would require the seal to be broken and the meter would then have to be re-certified; such an operation is not cost effective.

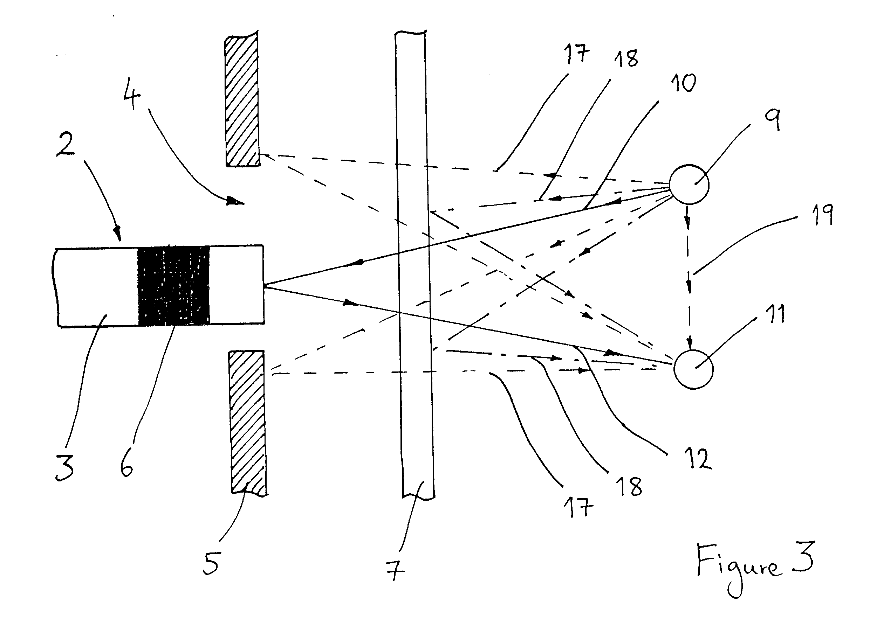

Secondly, it has been realised that, as shown in Figure 3, the photodetector 11 can also receive unwanted light signals which are at the selected frequency. For example, for the meter 1 of Figure 1, light from the LED 9 is reflected from the internal front panel 5 onto the photodetector 11 (ray paths 17 in Figure 3), from the window 7 onto the photodetector 11 (ray paths 18 in Figure 3), or as crosstalk between the LED 9 and photodetector 11 (ray path 19 in Figure 3). The effect of these unwanted signals is to increase the intensity of light reaching the photodetector but the size of the drop remains the same. However the output signal from the lock-in-amplifier 14 is increased, as shown by the broken line in Figure 2(c). If a maximum value Vₘₐₓ for the output is selected (Figure 2(d)), the size of the drop 15 in output may be reduced, as shown by the broken line in Figure 2(d) making it more difficult to reliably detect the drop 15.

It is an object of the present invention to provide a synchronous detector circuit arrangement which enables at least some of the aforementioned disadvantages to be considerably alleviated.

According to one aspect of the invention there is provided a synchronous detector circuit arrangement for detecting a signal of interest in an input signal, the input signal comprising a signal at a selected frequency which is modulated by the signal of interest and by an unwanted signal, the circuit arrangement characterised by comprising: signal combining means for combining the input signal with a correction signal; a synchronous detector connected to the output of the signal combining means and operated at the selected frequency for detecting the signal of interest; and means for generating the correction signal such that in operation the correction signal is a signal at the selected frequency, is in antiphase with the input signal and has an amplitude which is selected such as to at least partially cancel the unwanted signal.

Preferably the circuit arrangement includes means for setting the amplitude of the first signal at the input of the synchronous detector to a selected value such that the output of the synchronous detector has a maximum selected amplitude.

According to another aspect of the invention there is provided an optical pick-up for use with a commodity consumption meter, of the type having a rotating component whose rate of rotation depends on the rate of consumption of the commodity, the optical pick-up including a synchronous detector circuit arrangement according to the invention and further including an optical sensor comprising a light source which is modulated at the selected frequency and arranged to direct light onto the rotating component, and a light detector to detect reflected light from the rotating component, the output of which is connected to the synchronous detector circuit arrangement. An advantage of this aspect of the invention is that due to the circuit arrangement's enhanced detection ability precise alignment of the light source and photodetector with the rotating component is less important.

A synchronous detector circuit arrangement and an optical pick-up in accordance with the invention will now be described, by way of example, with reference to the accompanying drawings, in which:
Figure 1 is a prior art optical pick-up for use with an electricity consumption meter;
Figures 2(a) to (d) are waveforms for the optical pick-up of Figure 1;
Figure 3 is a ray diagram for the optical pick-up of Figure 1;
Figure 4 is a diagram of the optical pick-up and synchronous detector circuit arrangement in accordance with the invention; and
Figures 5(a) to (d) are plots of output voltage versus time for the synchronous detector circuit arrangement of Figure 4.

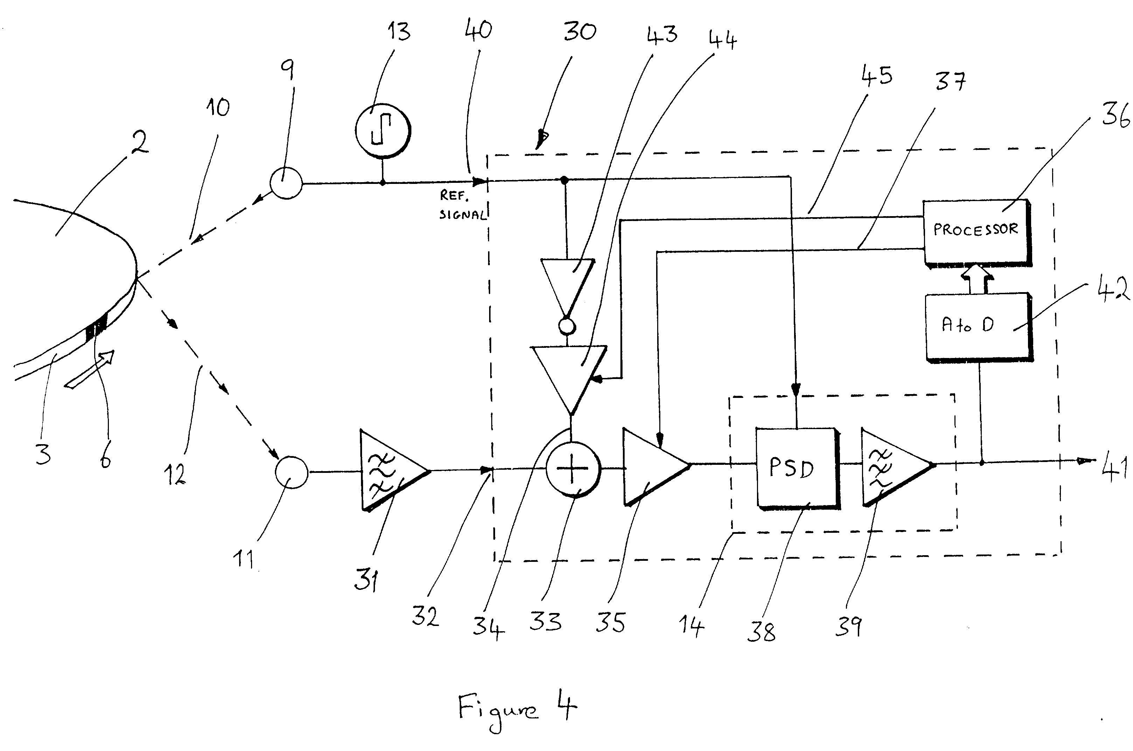

Referring to Figure 4, the pick-up includes an optical sensor and a synchronous detector circuit arrangement 30 intended for use with an electricity consumption meter (not shown). The optical sensor comprises a light source 9 and photodetector 11. An oscillator 13 is used to drive the light source 9 to produce pulses of light 10 at a selected frequency which are arranged to be incident upon the edge 3 of a disc 2 of the electricity consumption meter. Reflected light 12 from the edge 3 of the disc 2 is detected by the photodetector 11. A band pass filter 31 connected to the output of the photodetector 11 substantially attenuates all signals other than those at the selected frequency. The output signal from the band pass filter 31 constitutes the input signal which is applied to an input 32 of the synchronous detector circuit arrangement 30.

The synchronous detector circuit arrangement 30 comprises a summing circuit 33 for combining the input signal with a correction signal 34; the correction signal 34 is described below. The combined signal from the summing circuit 33 is amplified using a programmable gain amplifier (PGA) 35, the gain of which is set by a processor 36 by latching a digital value into the PGA 35 using a digital control line 37. A lock-in amplifier circuit 14 synchronously demodulates the output signal from the PGA 35.

The lock-in amplifier circuit 14 is a known arrangement and comprises a phase sensitive detector or demodulator (PSD) 38 and low pass filter 39. The PSD 38 is operated using a reference signal 40 which is derived from the oscillator 13. As is known the PSD 38 produces signal components at DC and twice the reference frequency for input signals which are at the selected frequency (these will include the amplitude modulated signal resulting from rotation of the disc) together with sum and difference signal components centred at the selected frequency for input signals that are not at the selected frequency. By suitable selection of the cut-off frequency of the low pass filter 39 only input signals at the selected frequency are detected.

The output from the lock-in amplifier 14 forms an analogue output 41 for the synchronous detector circuit arrangement 30. The analogue signal appearing at the output 41 is converted into digital data using an analogue to digital (A-to-D) converter 42. The processor 36 is arranged to use this digital data to calculate the amplitude of the correction signal 34.

The correction signal 34 comprises a signal at the selected frequency generated from the reference signal 40 by inverting the phase using phase inverter 43 and amplifying, or attenuating, the amplitude using a second programmable gain amplifier (PGA) 44. The gain of the second PGA 44 is set by the processor 36 using a second digital control line 45.

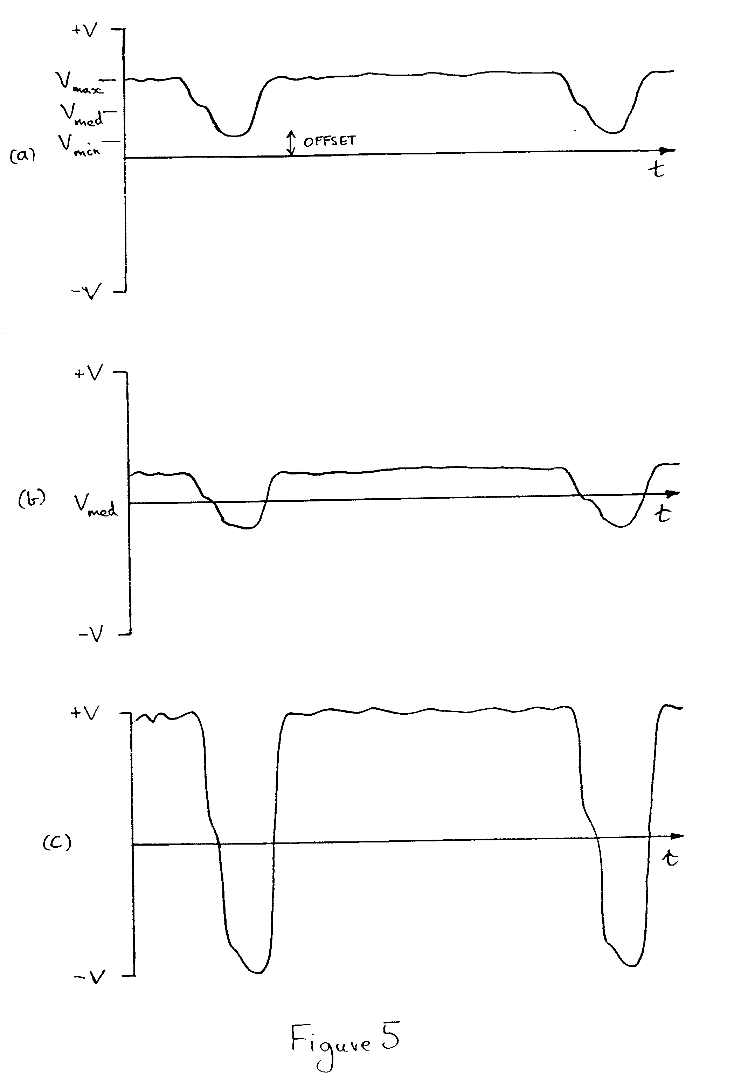

In operation, as described above with reference to Figure 3, the photodetector 11 can also receive unwanted signals at the selected frequency in the form of stray light reflections 17, 18 or 19. The intensity of this stray light however will be generally constant, or at least vary more slowly than the signal of interest resulting from the modulation of the reflected light 12 due to the rotation of the disc 2. Therefore the effect of these unwanted signals is to displace, or offset, the signal appearing at the output 41 by an amount V_{offset}, as shown in Figure 5(a). For maximum sensitivity the change in output should be as large as possible for a given change in input amplitude. In the limit therefore the change in output should be close to the rail voltages +V and -V requiring the median of the output V_{med} to be zero. The instantaneous value of V_{med} therefore gives a measure of the amount that the output needs to be displaced to obtain the required symmetrical swing in output.

The processor 36 is arranged to calculate V_{med} from the minimum and maximum amplitude output values, Vₘᵢₙ and Vₘₐₓ respectively which are determined by averaging over one or more rotations of the disc 2. The processor then increases the gain of the second PGA 44. Since the correction signal 34 has a frequency which is equal to the frequency of the reference signal 40 and a phase which is 180 degrees out of phase with the input signal, summing the correction signal 34 with the input signal displaces the output of the lock-in amplifier downwards and reduces the instantaneous value of V_{med}. The processor 36 continues to increase the gain of the second PGA 44 until the instantaneous value of V_{med} is close to zero, Figure 5(b). Having reduced the median level, the processor 36 increases the gain of the PGA 35 such that the swing in output voltage lies between the required maximum selected values -V and +V (Figure 5(c)).

A preferred feature of the present invention is in the generation of the correction signal 34 using a digital technique. This is because in the field of electricity consumption meters the rate of rotation of the disc 2 can vary over many orders of magnitude, for example from being stationary, at no load, to revolving at approximately two revolutions per second at full load. With the digital arrangement described the median output amplitude is determined under optimum conditions at all times. To attempt to determine this value using an analogue circuit would require complex circuitry with a variable time constant.

Another advantage of the invention is its ability to detect if the source 9 or photodetector 11 have been tampered with; since any form of tamper results in a marked change in output 41 of the lock-in amplifier 14 as the correction signal 34 is no longer correct. Whilst the foregoing discussion has been directed towards detecting rotation of the disc 2 in an electricity consumption meter, it will be appreciated that the invention can be applied to other types of commodity consumption meter which include any other form of rotating component such as a cyclometer register or the pointer of a dial register. Furthermore, the invention is not limited to the field of commodity consumption meters and is suitable for any application where synchronous detection is required and there are problems of unwanted signals which are at the selected frequency.

## Claims

1. A synchronous detector circuit arrangement (30) for detecting a signal of interest in an input signal, the input signal comprising a signal at a selected frequency which is modulated by the signal of interest and by an unwanted signal, the circuit arrangement characterised by comprising:
signal combining means (33) for combining the input signal with a correction signal (34);
a synchronous detector (14) connected to the output of the signal combining means and operated at the selected frequency for detecting the signal of interest; and
means (40, 43, 44) for generating the correction signal such that in operation the correction signal is a signal at the selected frequency, is in antiphase with the input signal and has an amplitude which is selected such as to at least partially cancel the unwanted signal.

2. A circuit arrangement, according to Claim 1, in which the correction signal (34) is generated by producing a digital signal representative of the required amplitude of the correction signal and utilising the digital signal to set the gain of a programmable gain amplifier (44).

3. A circuit arrangement, according to Claim 1 or Claim 2, in which the synchronous detector comprises a lock-in amplifier (14).

4. A circuit arrangement, according to any preceding claim, and further including means (35) for setting the amplitude of the first signal at the input of the synchronous detector to a selected value such that the output of the synchronous detector has a maximum selected value.

5. A circuit arrangement, according to any preceding claim, in which the signal of interest is derived from an optical signal (10) which has been reflected (12) from a rotating component (2).

6. A circuit arrangement, according to Claim 6, in which the optical signal (10) is directed at the rotating component (2) through a transparent member.

7. An optical pick-up for use with a commodity consumption meter (1) of the type having a rotating component (2) whose rate of rotation depends on the rate of consumption of the commodity, the optical pick-up including a synchronous detector circuit arrangement (14) according to any of claims 1 to 5 and further including an optical sensor (8) comprising a light source (9) which is modulated at the selected frequency and arranged to direct light (10) onto the rotating component (2) and a detector (11) to detect reflected light (12) from the rotating component (2), the output of which is connected to the synchronous detector circuit arrangement.
